# EUROPEAN PATENT APPLICATION

(11) **EP 4 568 086 A1**
(43) Date of publication of application: **11.06.2025**
(21) Application number: 23850449.2
(22) Date of filing: 03.08.2023
(51) Int. Cl.: H02M 1/00, H02M 1/08, H02M 3/158

(54) **SWITCHING REGULATOR FOR ADAPTIVELY DETECTING ZERO CURRENT, AND CONTROL METHOD THEREFOR**

(30) Priority: 04.08.2022 KR 20220097051; 02.08.2023 KR 20230101084
(71) Applicant: Lucid Microsystems Pte Ltd., Suwon-si Gyeonggi-do 16512 (KR)
(72) Inventor: LEE, Young Min, Seoul 05698 (KR)
(74) Representative: Boult Wade Tennant LLP
(86) International application number: PCT/KR2023/011393
(87) International publication number: WO 2024/029949

(57) **Abstract**

One embodiment provides a switching regulator comprising: a switch network including first, second, third and fourth switch blocks connected to one another in series, having a flying capacitor connected to a first node to which the first and second switch blocks are connected and a second node to which the third switch block and the fourth switch block are connected, and having an inductor connected to a third node to which the second and third switch blocks are connected; and a control circuit which compares a current value of one switch block from among the first, second, third and fourth switch blocks with a zero-current detection reference value so as to control zero-current switching for the one switch block, and which compares a voltage value of one end of the one switch block checked at one point after the zero-current switching with a voltage value at the other end so as to adjust the zero-current detection reference value.

## Description

### TECHNICAL FIELD

The present disclosure relates to a switching regulator.

### BACKGROUND ART

A switching regulator, which is an essential component of an electronic device, plays a crucial role in maintaining stability and efficiency of the electronic device by effectively performing power conversion and voltage control. However, when a switch is turned on or off in a switching regulator, switching losses can inevitably occur and noise, including electromagnetic waves, can sometimes be generated.

In order to solve such problems and improve performance of a switching regulator, a method of detecting and controlling zero currents may be generally applied to the switching regulator. Turning a switch on or off by a switching regulator in a state of zero currents can minimize unnecessary energy losses and ensure stable operation. However, there can be a time difference between the detection timing of zero currents and the timing of zero current switching of a switch. Such time differences may be caused by delays due to circuit configurations or switching operations. Due to such time differences, the aforementioned problems cannot be completely resolved.

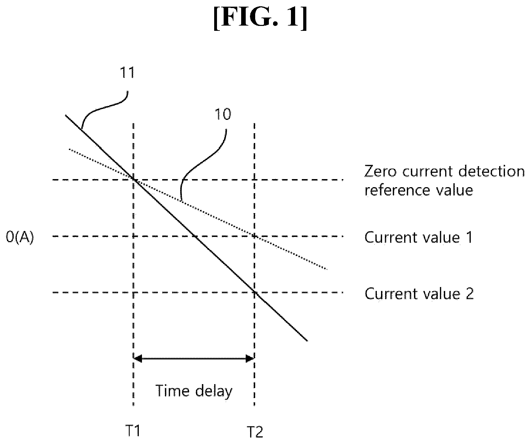

FIG. 1 is a diagram for illustrating a problem that zero current switching is not completely performed in a switching regulator according to a conventional art.

Referring to FIG. 1, the switching regulator may compare a current value of a switch and a zero current detection reference value at a first time point (T1). Based on a comparison result, the switching regulator may turn the switch off at a second time point (T2).

Between the first time point (T) and the second time point (T2), there may be a certain time delay. Such a time delay may be generated during the comparison between the current value of the switch and the zero current detection reference value or during the switch control, which is turning the switch off by supplying a gate signal to the switch.

Since there is a time delay between the time point (T1) where the current value of the switch and the zero current detection reference value are compared with each other and the time point (T2) where the switch is turned off, the switching regulator may set the absolute value of the zero current detection reference value to be higher than substantial 0(A). In case of a first current curve (10) in FIG. 1, the switching regulator sets the zero current detection reference value to a value higher than 0(A). Based on this setting, the switch is turned off when the current value of the switch (current value 1) reaches substantial 0(A) at the second time point (T2).

On the contrary, in case of a second current curve (11) in FIG. 1, since the slope of this curve is different from that of the first current curve even though the switching regulator sets the zero current detection reference value to the same value as that in the above case, the switch is turned off when the current value of the switch (current value 2) is lower than 0(A) at the second time point (T2). When the current value of the switch is lower or higher than 0(A) at the time point of turn-off of the switch, the zero current switching cannot be completely performed and the effect of reducing the switching loss and noise decreases.

In the mass production of switching regulators, zero current detection reference values may be adjusted through testing prior to their release. However, such tests are difficult and time-consuming because they involve current sweeps. Furthermore, if there is a change in an input current or an output current of the switching regulator, the aforementioned problems may arise again.

### DETAILED DESCRIPTION OF THE INVENTION

### TECHNICAL PROBLEM

Against this background, in an aspect, the present disclosure is to provide a technology for enhancing the efficiency of a switching regulator through optimal zero current switching. In another aspect, the present disclosure is to provide a technology for reducing the manufacturing time for a switching regulator by removing a process of adjusting a zero current detection reference value through mass production testing. In yet another aspect, the present disclosure is to provide a technology for adaptively setting a zero current detection reference value even under changes in an input voltage, an output voltage, or an inductance.

### TECHNICAL SOLUTION

To this end, an embodiment of the present disclosure provides a switching regulator comprising: a switch network, comprising a first switch block, a second switch block, a third switch block, and a fourth switch block, connected to a flying capacitor by a first node, to which the first switch block and the second switch block are connected, and by a second node, to which the third switch block and the fourth switch block are connected, and connected to an inductor by a third node, to which the second switch block and the third switch block are connected; and a control circuit configured to control zero current switching of one switch block among the first switch block, the second switch block, the third switch block, and the fourth switch block by comparing a current value of the one switch block with a zero current detection reference value and to adjust the zero current detection reference value by comparing a voltage value of one end of the one switch block and a voltage value of the other end thereof that are identified at one time point after the zero current switching.

Between a time point of comparing the current value of the one switch block with the zero current detection reference value and a time point of performing zero current switching control for the one switch block, there may be a certain time delay.

The control circuit may adjust the zero current detection reference value by turning off only the third switch block by the zero current switching control in a state where the first switch block and the third switch block are turned on, and comparing a drain voltage value and a source voltage value of the third switch block after the third switch block has been turned off.

When the drain voltage value of the third switch block is less than the source voltage value thereof after the third switch block has been turned off, the control circuit may determine that the third switch block was turned off in a state that a current was flowing from the third switch block to the inductor, and when the drain voltage value is greater than the source voltage value, the control circuit may determine that the third switch block was turned off in a state that a current was flowing from the inductor to the third switch block.

The control circuit may increase or decrease the zero current detection reference value based on the direction of a current.

The control circuit may adjust the zero current detection reference value by turning off only the fourth switch block by the zero current switching control in a state where the second switch block and the fourth switch block are turned on, and comparing a drain voltage value and a source voltage value of the fourth switch block after the fourth switch block has been turned off.

The control circuit may control the switch network to be in a first state where the first switch block and the second switch block are turned on, a second state where the third switch block and the fourth switch block are turned on, a third state where the first switch block and the third switch block are turned on, and a fourth state where the second switch block and the fourth switch block are turned on. Furthermore, the control circuit may control the switch network to be alternately in the first state and the second state so that the switch network may operate as a buck converter or a boost converter, and control the switch network to be alternately in the third state and the fourth state so that the switch network may operate as a resonant converter.

The control circuit may end the third state or the fourth state by the zero current switching.

The one switch block may include a transistor, a diode, and a parasitic capacitor arranged in parallel.

Another embodiment of the present disclosure provides a switching regulator comprising: one switch disposed in a path where an inductor current flows; and a control circuit configured to control zero current switching for the one switch by comparing a current value of the one switch with a zero current detection reference value and to adjust the zero current detection reference value by comparing a voltage value of one end and a voltage value of the other end of the one switch that are identified at one time point after the zero current switching.

Between a time point of comparing the current value of the one switch with the zero current detection reference value and a time point of performing zero current switching control for the one switch, there may be a certain time delay.

The control circuit may adjust the zero current detection reference value such that a difference between the voltage value of the one end of the one switch and the voltage value of the other end thereof decreases.

A drain of the one switch may be electrically connected to an inductor, and the control circuit may adjust the zero current detection reference value by comparing a drain voltage value of the one switch with a source voltage value thereof that are identified at one time point after the zero current switching.

Supposing that a direction of a current flowing from the one switch to the inductor is defined as a positive direction, when the drain voltage value is less than the source voltage value that are identified at one time point after the zero current switching, the control circuit may determine that the one switch was turned off in a situation where a current was flowing in the positive direction and, when the drain voltage value is greater than the source voltage value, the control circuit may determine that the one switch was turned off in a situation where a current was flowing in a negative direction.

The control circuit may increase or decrease the zero current detection reference value depending on the direction of a current.

### EFFECTS OF THE INVENTION

As described above, according to the present disclosure, the efficiency of a switching regulator may be enhanced through optimal zero current switching. Additionally, according to the present disclosure, the manufacturing time for a switching regulator may be reduced by removing a process of adjusting a zero current detection reference value through mass production testing. Further, according to the present disclosure, a zero current detection reference value may be adaptively set even under changes in an input voltage, an output voltage, or an inductance of a switching regulator.

### BRIEF DESCRIPTION OF THE DRAWINGS

FIG. 1 is a diagram for illustrating a problem where zero current switching is not fully performed in a switching regulator according to a conventional art.
FIG. 2 is a configuration diagram of a switching regulator according to an embodiment.
FIG. 3 is a diagram illustrating a zeroth state of a switch network according to an embodiment.
FIG. 4 is a diagram illustrating a first state of a switch network according to an embodiment.
FIG. 5 is a diagram illustrating a second state of a switch network according to an embodiment.
FIG. 6 is a diagram illustrating a third state of a switch network according to an embodiment.
FIG. 7 is a diagram illustrating a fourth state of a switch network according to an embodiment.
FIG. 8 is a diagram illustrating a fifth state of a switch network according to an embodiment.
FIG. 9 is a diagram illustrating a sixth state of a switch network according to an embodiment.
FIG. 10 is a diagram illustrating a pulse-shaping of an inductor current using a third state and a fourth state according to an embodiment.
FIG. 11 is a diagram illustrating main waveforms when a third switch is turned off in a state where a current flows in a positive direction according to an embodiment.
FIG. 12 is a diagram illustrating main waveforms when a third switch is turned off in a state where a current flows in a negative direction according to an embodiment.
FIG. 13 is a diagram illustrating main waveforms when a fourth switch is turned off in a state where a current flows in a positive direction according to an embodiment.
FIG. 14 is a diagram illustrating main waveforms when a fourth switch is turned off in a state where a current flows in a negative direction according to an embodiment.

### MODE FOR IMPLEMENTING THE INVENTION

Hereinafter, embodiments of the present disclosure are described in detail with reference to the accompanying drawings. With regard to the reference numerals of the components of the respective drawings, it should be noted that the same reference numerals are assigned to the same components even when the components are shown in different drawings. In addition, in the following description, when it was determined that a detailed description of a related known technology or function may obscure the gist of the present disclosure, the detailed description thereof has been omitted.

In addition, terms, such as "1st", "2nd", "A", "B", "(a)", "(b)", or the like, may be used in describing the components of the present disclosure. These terms are intended only to distinguish a corresponding component from other components, and the nature, order, or sequence of the corresponding component is not limited to the terms. In the case where a component is described as being "coupled", "combined", or "connected" to another component, it should be understood that the corresponding component may be directly coupled or connected to another component or that the corresponding component may also be "coupled", "combined", or "connected" to the component via another component provided therebetween.

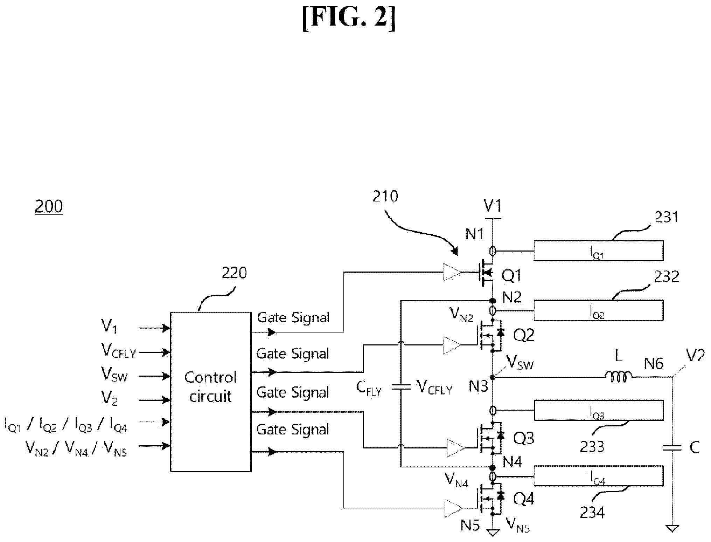

FIG. 2 is a configuration diagram of a switching regulator according to an embodiment.

Referring to FIG. 2, a switching regulator (200) may comprise a switch network (210), a control circuit (220), and current sensors (231 - 234).

The switching regulator (200) may convert power with a first voltage (V1) inputted through a first node (N1) to generate power with a second voltage (V2) and output the power through a sixth node (N6). Otherwise, the switching regulator (200) may convert power with the second voltage (V2) inputted through the sixth node (N6) to generate power with the first voltage (V1) and output the power through the first node (N1).

The switch network (210) may include a first switch block, a second switch block, a third switch block, and a fourth switch block connected to each other in series.

Each switch block may include at least one switch. For example, the first switch block may include a first switch (Q1), the second switch block may include a second switch (Q2), the third switch block may include a third switch (Q3), and the fourth switch block may include a fourth switch (Q4). Descriptions below are focused on an example where each switch block include one switch for the convenience of the description. However, the present disclosure is not limited to such an example.

Hereinafter, control for the first switch (Q1) may be understood as control for the first switch block, control for the second switch (Q2) may be understood as control for the second switch block, control for the third switch (Q3) may be understood as control for the third switch block, and control for the fourth switch (Q4) may be understood as control for the fourth switch block. For example, turning off the first switch (Q1) may be understood as turning off the first switch block and turning on the second switch (Q2) may be understood as turning on the second switch block.

The first switch (Q1), the second switch (Q2), the third switch (Q3), and the fourth switch (Q4) may be power semiconductors. For example, the first switch (Q1), the second switch (Q2), the third switch (Q3), and the fourth switch (Q4) may be Metal Oxide Semiconductor Field Effect Transistors (MOSFETs), Insulated Gate Bipolar Transistors (IGBTs), or other forms of power semiconductors. Each of the first switch (Q1), the second switch (Q2), the third switch (Q3), and the fourth switch (Q4) may include a transistor, a diode, and a parasitic capacitor arranged in parallel. A transistor, a diode, and a parasitic capacitor may be naturally included based on characteristics of a power semiconductor such as a MOSFET. Otherwise, they may be included by an additional component such as a backward diode attached in parallel to an IGBT.

The first switch (Q1), the second switch (Q2), the third switch (Q3), and the fourth switch (Q4) may be connected to each other in series. For example, the first switch (Q1) and the second switch (Q2) may be connected to each other through a second node (N2), the second switch (Q2) and the third switch (Q3) may be connected to each other through a third node (N3), and the third switch (Q3) and the fourth switch (Q4) may be connected to each other through a fourth node (N4).

A first node (N1) may be formed on one side of the first switch (Q1) and the second node (N2) may be formed on the other side thereof, wherein a first voltage (V1) may be supplied or outputted through the first node (N1). A fifth node (N5) may be formed on one side of the fourth switch (Q4) and a fourth node (N4) may be formed on the other side thereof, wherein a low voltage - for example, a ground voltage - may be supplied through the fifth node (N5). The first voltage (V1) supplied through the first node (N1) may be relatively higher than the low voltage supplied through the fifth node (N5). Accordingly, a voltage supplied through the first node (N1) may be referred to as a high voltage and a voltage supplied through the fifth node (N5) may be referred to as a low voltage.

To the switch network (211), an inductor (L) and a flying capacitor (C_{FLY}) may be connected.

The flying capacitor (C_{FLY}) may be connected in its one side to the second node (N2) to which the first switch (Q1) and the second switch (Q2) are connected and in its other side to the fourth node (N4) to which the third switch (Q3) and the fourth switch (Q4) are connected.

The inductor (L) may be connected in its one side to the third node (N3) to which the second switch (Q2) and the third switch (Q3) are connected and in its other side to a sixth node (N6) through which the second voltage (V2) is outputted.

Additionally, an output capacitor (C) may be disposed between the sixth node (N6) and the low voltage.

The control circuit (220) may control the switches (Q1 - Q4) included in the switch network (210). The control circuit (220) may control the switch network (210) to be in a plurality of states by turning the switches (Q1 - Q4) on or off.

The control circuit (220) may turn each of the switches (Q1 - Q4) on or off by transmitting a gate signal to a gate of each of the switches (Q1 - Q4).

The control circuit (220) may operate at least one of the switches (Q1 - Q4) in a linear mode. When the at least one switch operates in the linear mode, the amount of current flowing into the at least one switch may be limited to a predetermined level according to a gate signal.

The control circuit (220) may sense currents, voltages, etc. of the switch network (210) or each of the nodes (N1 - N6) and change the state of the switch network (210) using sensed values.

For example, the control circuit (220) may sense the first voltage (V1), the second voltage (V2), a flying capacitor voltage (V_{CFLY}), a voltage of the third node (V_{SW}), etc. Additionally, the control circuit (220) may sense a current of the first switch (I_{Q1}), a current of the second switch (I_{Q2}), a current of the third switch (I_{Q3}), a current of the fourth switch (I_{Q4}), etc.

The control circuit (220) may determine or change the state of the switch network (210) using at least one sensed value among the first voltage (V1), the second voltage (V2), the flying capacitor voltage (V_{CFLY}), the voltage of the third node (V_{SW}), the current of the first switch (I_{Q1}), the current of the second switch (I_{Q2}), the current of the third switch (I_{Q3}), and the current of the fourth switch (I_{Q4}).

All of the aforementioned values may be sensed or only some may be sensed. For example, the control circuit (220) may sense only one of the current of the first switch (I_{Q1}) and the current of the third switch (I_{Q3}) or only one of the current of the second switch (I_{Q2}) and the current of the fourth switch (I_{Q4}).

The control circuit (220) may control the switch network (210) to be in seven states described below.

When changing the state, the control circuit (220) may perform zero current switching control. Here, the control circuit (220) may adjust a zero current detection reference value depending on voltage values of one side and the other side of each of the switches (Q1 - Q4) or voltages of the respective nodes (V_{N2}, V_{SW}, V_{N4}, V_{N5}) of the switch network (210) to adaptively detect a zero current and to enhance the efficiency of the switching regulator (200).

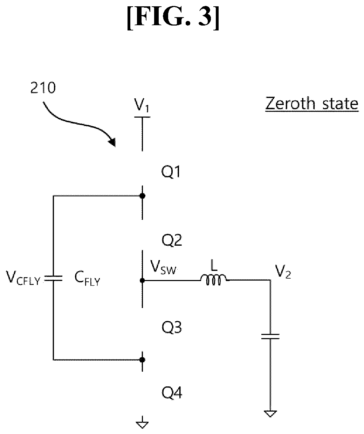

FIG. 3 is a diagram illustrating a zeroth state of a switch network according to an embodiment.

Referring to FIG. 3, the control circuit may turn off all the switches (Q1 - Q4) of the switch network (210) to control the switch network (210) to be in the zeroth state.

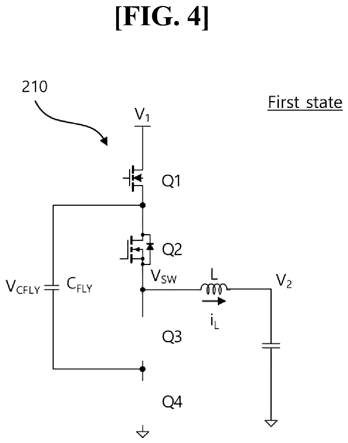

FIG. 4 is a diagram illustrating a first state of a switch network according to an embodiment.

Referring to FIG. 4, the control circuit may turn on the first switch (Q1) and the second switch (Q2) and turn off the third switch (Q3) and the fourth switch (Q4) to control the switch network (210) to be in the first state.

In the first state, the flying capacitor (C_{FLY}) may float and the flying capacitor voltage (V_{CFLY}) may be maintained at a predetermined level.

Through one side of the first switch (Q1), the first voltage (V1) - a high voltage - may be supplied and the first voltage (V1) may be supplied to one side of the inductor (L) by turning on the first switch (Q1) and the second switch (Q2) and turning off the third switch (Q3) and the fourth switch (Q4) in the first state.

To the other side of the inductor (L), the second voltage (V2) may be supplied. Accordingly, in the first state, the first voltage (V1) may be supplied to the one side of the inductor (L) and the second voltage (V2) may be supplied to the other side thereof. By these voltages (V1, V2), an inductor current (i_{L}) may build up in the first state.

Operations in the first state may be identical to operations in a buck converter or a boost converter.

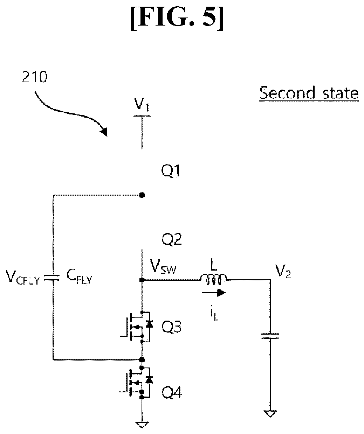

FIG. 5 is a diagram illustrating a second state of a switch network according to an embodiment.

Referring to FIG. 5, the control circuit may turn off the first switch (Q1) and the second switch (Q2) and turn on the third switch (Q3) and the fourth switch (Q4) to control the switch network (210) to be in the second state.

In the second state, the flying capacitor (C_{FLY}) may float and its voltage (V_{CFLY}) may be maintained at a predetermined level.

Through one side of the fourth switch (Q4), the ground voltage - the low voltage - may be supplied and the ground voltage - the low voltage - may be supplied to one side of the inductor (L) by turning off the first switch (Q1) and the second switch (Q2) and turning on the third switch (Q3) and the fourth switch (Q4) in the second state.

To the other side of the inductor (L), the second voltage (V2) may be supplied. Accordingly, in the second state, the ground voltage - the low voltage - may be supplied to the one side of the inductor (L) and the second voltage (V2) may be supplied to the other side thereof. By these voltages, an inductor current (i_{L}) may build up in the second state.

The inductor current (i_{L}) may build up in opposite directions in the first state and the second state. For example, supposing that a direction of a current flowing from the one side to the other side of the inductor (L) is a positive direction, the inductor current (i_{L}) may build up in an increasing direction in the first state and the inductor current (i_{L}) may build up in a decreasing direction in the second state.

Operations in the second state may be identical to operations in a buck converter or a boost converter.

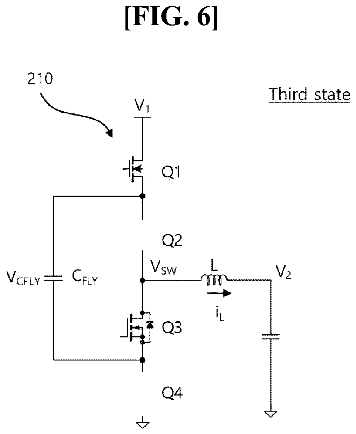

FIG. 6 is a diagram illustrating a third state of a switch network according to an embodiment.

Referring to FIG. 6, the control circuit may turn on the first switch (Q1) and the third switch (Q3) and turn off the second switch (Q2) and the fourth switch (Q4) to control the switch network (210) to be in the third state.

In the third state, the flying capacitor (C_{FLY}) and the inductor (L) may be connected to each other in series so that the inductor current (i_{L}) and the flying capacitor voltage (V_{CFLY}) may form resonant waveforms.

In the third state, the inductor current (i_{L}) may form a resonant waveform that increases and then decreases. Based on such a resonant waveform of the inductor current (i_{L}), the control circuit may turn off or on the respective switches (Q1 - Q4) in the zero current.

Operations in the third state may be identical to operations in a resonant converter.

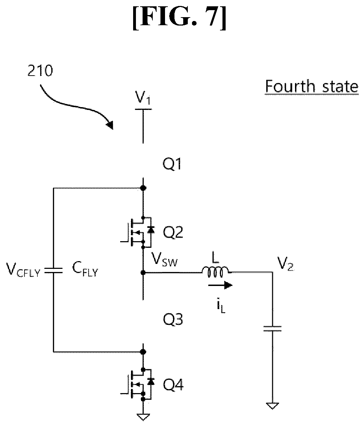

FIG. 7 is a diagram illustrating a fourth state of a switch network according to an embodiment.

Referring to FIG. 7, the control circuit may turn off the first switch (Q1) and the third switch (Q3) and turn on the second switch (Q2) and the fourth switch (Q4) to control the switch network (210) to be in the fourth state.

In the fourth state, the flying capacitor (C_{FLY}) and the inductor (L) may be connected to each other in series so that the inductor current (i_{L}) and the flying capacitor voltage (V_{CFLY}) may form resonant waveforms.

In the fourth state, the inductor current (i_{L}) may form a resonant waveform that increases and then decreases. Based on such a resonant waveform of the inductor current (i_{L}), the control circuit may turn off or on the respective switches (Q1 - Q4) in the zero current.

Operations in the fourth state may be identical to operations in a resonant converter.

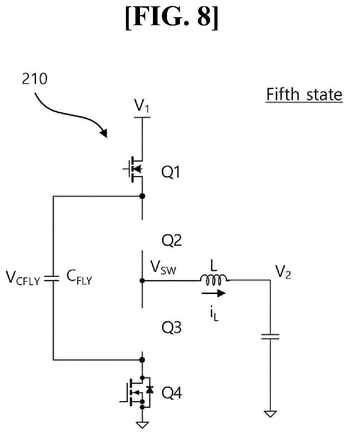

FIG. 8 is a diagram illustrating a fifth state of a switch network according to an embodiment.

Referring to FIG. 8, the control circuit may turn on the first switch (Q1) and the fourth switch (Q4) and turn off the second switch (Q2) and the third switch (Q3) to control the switch network (210) to be in the fifth state.

In an initial operation or an abnormal situation, when the flying capacitor voltage (V_{CFLY}) is lower than a predetermined voltage range or a predetermined voltage level, the control circuit may control the switch network (210) to be in the fifth state.

In the fifth state, a current path may be formed in series among the first voltage (V1), the first switch (Q1), the flying capacitor (C_{FLY}), the fourth switch (Q4), and the ground voltage and the flying capacitor (C_{FLY}) may be charged with a current of this current path.

In order to prevent an excessive current - for example, an inrush current - from flowing into the first switch (Q1) and/or the fourth switch (Q4) in the fifth state, the control circuit may operate the first switch (Q1) and/or the fourth switch (Q4) in a linear mode. Here, the control circuit may sense currents flowing into the first switch (Q1) and/or the fourth switch (Q4) and control the first switch (Q1) and/or the fourth switch (Q4) based on sensed values.

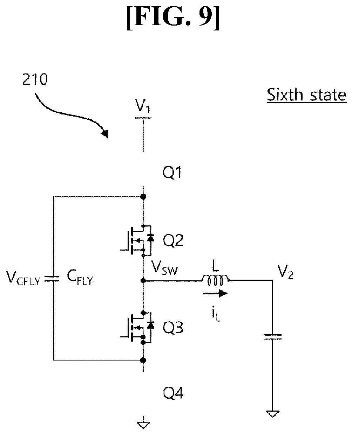

FIG. 9 is a diagram illustrating a sixth state of a switch network according to an embodiment.

Referring to FIG. 9, the control circuit may turn off the first switch (Q1) and the fourth switch (Q4) and turn on the second switch (Q2) and the third switch (Q3) to control the switch network (210) to be in the sixth state.

In an abnormal situation, when the flying capacitor voltage (V_{CFLY}) is higher than a predetermined voltage range or a predetermined voltage level, the control circuit may control the switch network (210) to be in the sixth state.

In the sixth state, the second switch (Q2) and the third switch (Q3) may be arranged in parallel to the flying capacitor (C_{FLY}). Through the second switch (Q2) and the third switch (Q3), the flying capacitor (C_{FLY}) may be discharged.

In order to prevent an excessive current from flowing into the second switch (Q2) and/or the third switch (Q3) in the sixth state, the control circuit may operate the second switch (Q2) and/or the third switch (Q3) in a linear mode. Here, the control circuit may sense currents flowing into the second switch (Q2) and/or the third switch (Q3) and control the second switch (Q2) and/or the third switch (Q3) based on sensed values.

The control circuit may control the switch network to be alternately in the third state and the fourth state.

The switching regulator according to an embodiment may cause power to be transferred through the resonance of the flying capacitor and inductor.

The control circuit may operate the switch network in the third state and the fourth state with a resonant frequency of the flying capacitor and inductor or a frequency close to the resonant frequency. In this way, power can be transferred through the resonance of the flying capacitor and the inductor like a resonant converter.

The third state and the fourth state may be controlled to alternate. For example, the switch network may operate in the third state followed by operating in the fourth state, and then operate in the third state after having operated in the fourth state.

When an inductor current forming one rising/falling waveform by the inductor current's increasing and decreasing is referred to as a pulse-shaping, one pulse-shaping may be formed in each of the third state and the fourth state.

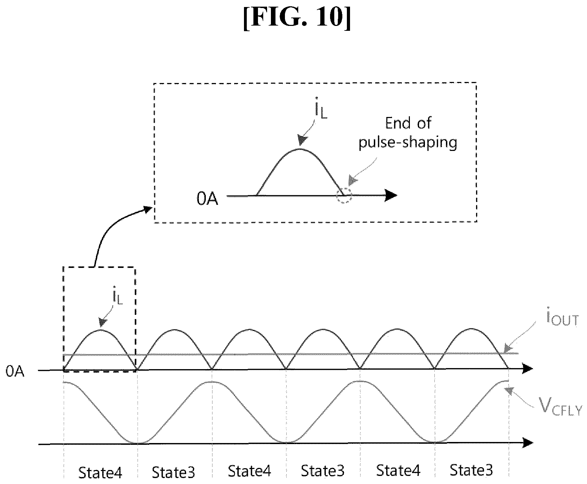

FIG. 10 is a diagram illustrating a pulse-shaping of an inductor current using a third state and a fourth state according to an embodiment.

Referring to FIG. 10, the control circuit may control the switch network to be alternately in the third state and the fourth state.

When the inductor current (i_{L}) reaches a zero current level, the control circuit may end the third state or the fourth state.

In the third state, the flying capacitor may be charged and the flying capacitor voltage (V_{CFLY}) may increase. The inductor current (i_{L}) may increase and then decrease. When the inductor current (i_{L}) reaches the zero current level - a level within a predetermined error range from zero - in the third state, the control circuit may end the third state to form the end of the pulse-shaping.

In the fourth state, the flying capacitor may be discharged and the flying capacitor voltage (V_{CFLY}) may decrease. The inductor current (i_{L}) may increase and then decrease. When the inductor current (i_{L}) reaches the zero current level - a level within a predetermined error range from zero - in the fourth state, the control circuit may end the fourth state to form the end of the pulse-shaping.

In order to more accurately form such a pulse-shaping, the control circuit may adaptively detect the zero current and control switch network based on the detection.

The control circuit may control zero current switching of each switch by comparing a current value of the switch with a zero current detection reference value. The control circuit may more accurately control the zero current switching by adjusting the zero current detection reference value depending on characteristics of the switch network. Here, the zero current switching control is a concept that incorporates both zero current turn-off control and zero current turn-on control. For the convenience of the description, the below descriptions are focused on an example of the zero current turn-off control.

The control circuit may adjust the zero current detection reference value depending on a direction of a current when performing the zero current switching. In order to describe such an example, a direction of a current flowing from one side to the other side of the inductor - a direction of a current flowing from the third node (N3 in FIG. 2) to the sixth node (N6 in FIG. 2) - is defined as a positive direction.

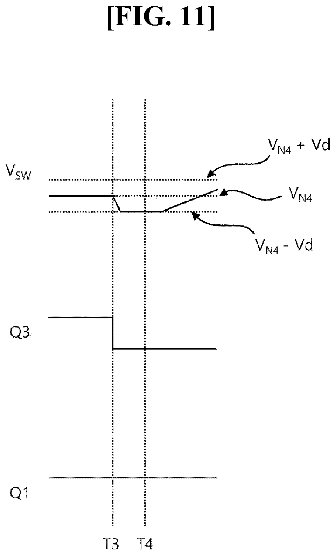

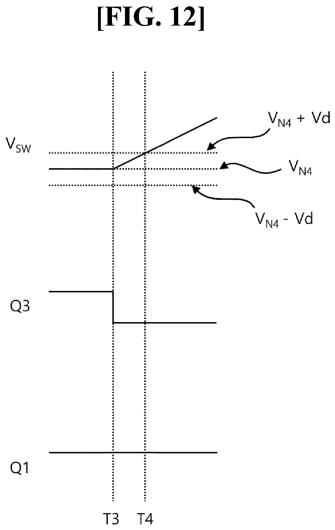

FIG. 11 is a diagram illustrating main waveforms when a third switch is turned off in a state where a current flows in a positive direction according to an embodiment and FIG. 12 is a diagram illustrating main waveforms when a third switch is turned off in a state where a current flows in a negative direction according to an embodiment.

Referring to FIG. 11 and FIG. 12, the control circuit may turn off the third switch (Q3) at a third time point (T3). Although it is not shown in the figure, the control circuit may compare a current value of the third switch (Q3) with the zero current detection reference value at a time point earlier than the third time point (T3) to control the zero current switching (here, turn-off) of the third switch (Q3). The third switch (Q3) may practically be turned off at the third time point (T3).

Referring to FIG. 11, at one time point (T4) after the zero switching, a drain voltage (V_{SW}) of the third switch (Q3) may be a lower voltage (V_{N4} - Vd) than a source voltage (V_{N4}). Such a waveform may be shown when a current flows in a positive direction. Here, Vd, which is a difference between the drain voltage (V_{SW}) and the source voltage (V_{N4}), may be identical to a forward drop voltage of a diode of the third switch (Q3).

Referring to FIG. 12, at one time point (T4) after the zero switching, the drain voltage (V_{SW}) of the third switch (Q3) may be a higher voltage (V_{N4} + Vd) than the source voltage (V_{N4}). Such a waveform may be shown when a current is formed in a negative direction. Here, Vd, which is a difference between the drain voltage (V_{SW}) and the source voltage (V_{N4}), may be identical to a voltage formed in a parasitic capacitor of the third switch (Q3).

The control circuit may identify the direction of a current by comparing the drain voltage value and the source voltage value and increase or decrease the zero current detection reference value based on the direction of the current. When the zero current detection reference value is high and the current flows in the positive direction, the zero current switching control is highly likely to be performed and, when the zero current detection reference value is low and the current flows in the negative direction, the zero current switching control is also highly likely to be performed. Accordingly, when the direction of the current is identified to be positive by the drain voltage value and the source voltage value, the control circuit may decrease the zero current detection reference value and, when the direction of the current is identified to be negative, the control circuit may increase the zero current detection reference value. Otherwise, the control circuit may increase or decrease the zero current detection reference value such that the drain voltage value and the source voltage value decrease.

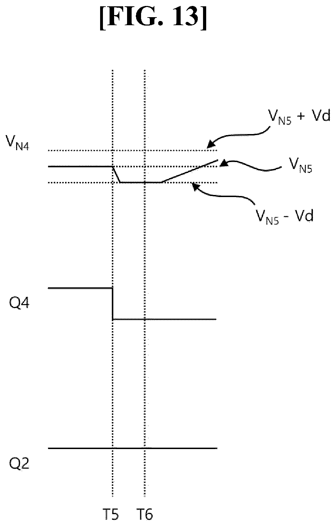

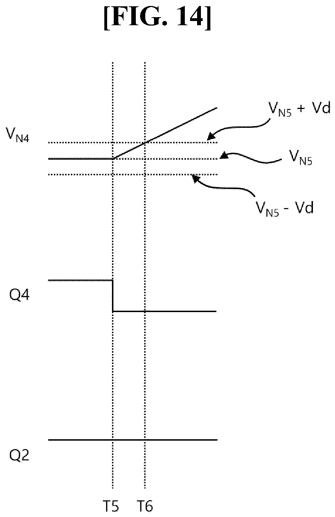

FIG. 13 is a diagram illustrating main waveforms when a fourth switch is turned off in a state where a current flows in a positive direction according to an embodiment and FIG. 14 is a diagram illustrating main waveforms when a fourth switch is turned off in a state where a current flows in a negative direction according to an embodiment.

Referring to FIG. 13 and FIG. 14, the control circuit may turn off the fourth switch (Q4) at a fifth time point. Although it is now shown in the figure, the control circuit may compare a current value of the fourth switch (Q4) with the zero current detection reference value at a time point earlier than the fifth time point (T5) to control the zero current switching (here, turn-off) of the fourth switch (Q4). The fourth switch (Q4) may practically be turned off at the fifth time point (T5).

Referring to FIG. 13, at one time point (T6) after the zero switching, a drain voltage (V_{N4}) of the fourth switch (Q4) may be a lower voltage (V_{N5} - Vd) than a source voltage (V_{N5}). Such a waveform may be shown when a current flows in a positive direction. Here, Vd, which is a difference between the drain voltage (V_{N4}) and the source voltage (V_{N5}), may be identical to a forward drop voltage of a diode of the fourth switch (Q4).

Referring to FIG. 14, at one time point (T6) after the zero switching, the drain voltage (V_{N4}) of the fourth switch (Q4) may be a higher voltage (V_{N5} + Vd) than the source voltage (V_{N2}). Such a waveform may be shown when a current flows in a negative direction. Here, Vd, which is a difference between the drain voltage (V_{N4}) and the source voltage (V_{N5}), may be identical to a voltage formed in a parasitic capacitor of the fourth switch (Q4).

The control circuit may identify the direction of a current by comparing the drain voltage value and the source voltage value and increase or decrease the zero current detection reference value based on the direction of the current. When the zero current detection reference value is high and the current flows in the positive direction, the zero current switching control is highly likely to be performed and, when the zero current detection reference value is low and the current flows in the negative direction, the zero current switching control is also highly likely to be performed. Accordingly, when the direction of the current is identified to be positive by the drain voltage value and the source voltage value, the control circuit may decrease the zero current detection reference value and, when the direction of the current is identified to be negative, the control circuit may increase the zero current detection reference value. Otherwise, the control circuit may increase or decrease the zero current detection reference value such that the drain voltage value and the source voltage value decrease.

The adjustment of the zero current detection reference value may be performed periodically or non-periodically. For example, the control circuit may adjust the zero current detection reference value every switching period or once every N (N is a natural number equal to 2 or greater) switching periods.

As described above, the present disclosure enables enhancing the efficiency of a switching regulator through optimal zero current switching. The present disclosure also enables reducing the manufacturing time for a switching regulator by removing a process of adjusting a zero current detection reference value through mass production testing. Further, the present disclosure enables adaptively setting a zero current detection reference value even under changes in an input voltage, an output voltage, and an inductance.

Terms, such as "include", "consist of", or "have" described above, mean that the corresponding component may be present unless otherwise stated. Thus, the terms should be construed that the terms do not exclude other components but may further include other components. All terms, including technical or scientific terms, have the same meaning as commonly understood by those having ordinary skill in the art to which the present disclosure belongs, unless defined otherwise. Generally used terms, such as terms defined in the dictionary, should be interpreted as being consistent with the contextual meaning of the related art and should not be interpreted in an ideal or excessively formal meaning unless explicitly defined in the present disclosure.

The above descriptions merely illustrate the technical idea of the present disclosure. Those having ordinary skill in the art to which the present disclosure belongs may perform various modification and changes within the scope and without departing from the essential characteristics of the present disclosure. Accordingly, the embodiments disclosed in the present disclosure are not intended to limit but to explain the technical idea of the present disclosure. The scope of the technical spirit of the present disclosure is not limited by these embodiments. The scope of protection of the present disclosure should be interpreted by the claims below, and all technical spirits within the scope equivalent to the scope of the claims should be interpreted as being included in the scope of the claims of the present disclosure.

## Claims

1. A switching regulator comprising:
a switch network, comprising a first switch block, a second switch block, a third switch block, and a fourth switch block, connected to a flying capacitor by a first node, to which the first switch block and the second switch block are connected, and by a second node, to which the third switch block and the fourth switch block are connected, and connected to an inductor by a third node, to which the second switch block and the third switch block are connected; and
a control circuit configured to control zero current switching of one switch block among the first switch block, the second switch block, the third switch block, and the fourth switch block by comparing a current value of the one switch block with a zero current detection reference value and to adjust the zero current detection reference value by comparing a voltage value of one end of the one switch block and a voltage value of the other end thereof that are identified at one time point after the zero current switching.

2. The switching regulator of claim 1, wherein there is a certain time delay between a time point of comparing the current value of the one switch block with the zero current detection reference value and a time point of performing zero current switching control for the one switch block.

3. The switching regulator of claim 1, wherein the control circuit adjusts the zero current detection reference value by turning off only the third switch block by the zero current switching control in a state where the first switch block and the third switch block are turned on, and comparing a drain voltage value and a source voltage value of the third switch block after the third switch block has been turned off.

4. The switching regulator of claim 3, wherein, when the drain voltage value of the third switch block is less than the source voltage value thereof after the third switch block has been turned off, the control circuit determines that the third switch block was turned off in a state that a current was flowing from the third switch block to the inductor and, when the drain voltage value is greater than the source voltage value, the control circuit determines that the third switch block was turned off in a state that a current was flowing from the inductor to the third switch block.

5. The switching regulator of claim 4, wherein the control circuit increases or decreases the zero current detection reference value based on the direction of a current.

6. The switching regulator of claim 1, wherein the control circuit adjusts the zero current detection reference value by turning off only the fourth switch block by the zero current switching control in a state where the second switch block and the fourth switch block are turned on, and comparing a drain voltage value and a source voltage value of the fourth switch block after the fourth switch block has been turned off.

7. The switching regulator of claim 1,
wherein control circuit controls the switch network to be in a first state where the first switch block and the second switch block are turned on, a second state where the third switch block and the fourth switch block are turned on, a third state where the first switch block and the third switch block are turned on, and a fourth state where the second switch block and the fourth switch block are turned on, and
wherein the control circuit controls the switch network to be alternately in the first state and the second state so that the switch network may operate as a buck converter or a boost converter, and controls the switch network to be alternately in the third state and the fourth state so that the switch network may operate as a resonant converter.

8. The switching regulator of claim 7, wherein the control circuit ends the third state or the fourth state by the zero current switching.

9. The switching regulator of claim 1, wherein the one switch block includes a transistor, a diode, and a parasitic capacitor arranged in parallel.

10. A switching regulator comprising:
one switch disposed in a path where an inductor current flows; and
a control circuit configured to control zero current switching for the one switch by comparing a current value of the one switch with a zero current detection reference value and to adjust the zero current detection reference value by comparing a voltage value of one end and a voltage value of the other end of the one switch that are identified at one time point after the zero current switching.

11. The switching regulator of claim 10, wherein there is a certain time delay between a time point of comparing the current value of the one switch with the zero current detection reference value and a time point of performing zero current switching control for the one switch

12. The switching regulator of claim 10, wherein the control circuit adjusts the zero current detection reference value such that a difference between the voltage value of the one end of the one switch and the voltage value of the other end thereof decreases.

13. The switching regulator of claim 10, wherein a drain of the one switch is electrically connected to an inductor, and the control circuit adjusts the zero current detection reference value by comparing a drain voltage value of the one switch with a source voltage value thereof that are identified at one time point after the zero current switching.

14. The switching regulator of claim 13, wherein, supposing that a direction of a current flowing from the one switch to the inductor is defined as a positive direction, when the drain voltage value is less than the source voltage value that are identified at one time point after the zero current switching, the control circuit determines that the one switch is turned off in a situation where a current flows in the positive direction and, when the drain voltage value is greater than the source voltage value, the control circuit determines that the one switch is turned off in a situation where a current flows in a negative direction.

15. The switching regulator of claim 14, wherein the control circuit increases or decreases the zero current detection reference value depending on the direction of a current.
